# EUROPEAN PATENT SPECIFICATION

(11) **EP 4 524 585 B1**
(45) Date of publication and mention of the grant of the patent: **04.11.2026**
(21) Application number: 23870124.7
(22) Date of filing: 30.08.2023
(51) Int. Cl.: G01R 31/36, G01R 31/382, H01M 10/42, H01M 10/48, G01R 31/374, G01R 31/392, G01R 31/367

(54) **BATTERY CAPACITY ESTIMATION METHOD, ELECTRONIC DEVICE AND STORAGE MEDIUM**
VERFAHREN ZUR SCHÄTZUNG DER BATTERIEKAPAZITÄT, ELEKTRONISCHE VORRICHTUNG UND SPEICHERMEDIUM
PROCÉDÉ D'ESTIMATION DE CAPACITÉ DE BATTERIE, DISPOSITIF ÉLECTRONIQUE ET SUPPORT DE STOCKAGE

(30) Priority: 28.09.2022 CN 202211189620
(43) Date of publication of application: 19.03.2025
(73) Proprietor: Sunwoda Mobility Energy Technology Co., Ltd., Shenzhen, Guangdong 518107 (CN)
(72) Inventor: LIN, Haijun, Shenzhen, Guangdong 518107 (CN); LI, Jianjie, Shenzhen, Guangdong 518107 (CN); YI, Xingyun, Shenzhen, Guangdong 518107 (CN); CHEN, Binbin, Shenzhen, Guangdong 518107 (CN)
(74) Representative: Ostriga PartGmbB
(86) International application number: PCT/CN2023/115799
(87) International publication number: WO 2024/066883

(56) References cited:
- WO-A1-2020/188284
- CN-A- 103 616 647
- CN-A- 103 616 647
- CN-A- 107 748 342
- CN-A- 107 748 342
- CN-A- 109 061 497
- CN-A- 109 521 370
- CN-A- 109 946 623
- CN-A- 111 308 357
- CN-A- 111 308 357
- CN-A- 112 415 410
- CN-A- 113 030 742
- CN-A- 114 545 241
- CN-A- 114 545 241
- CN-A- 115 113 076
- CN-A- 115 436 809

## Description

### TECHNICAL FIELD

The present application relates to the technical field of batteries, and in particular, to a battery capacity estimation method, an electronic device and a storage medium.

### BACKGROUND

After batteries are assembled into a battery pack, temperature sensor sampling points will be arranged throughout the battery pack. During the discharge process, due to the concentrated heating of the battery, the temperature of local points rises rapidly, while the temperature rise at the opposite edges of the battery is slower than that at the local points. Meanwhile, due to the limited number of temperature sensor sampling points, when the temperature sensor sampling points fail to cover the opposite edges, that is, the actual lowest temperature of the battery cannot be collected, the temperature collected by the temperature collecting sensor is higher than the actual temperature. During the standing process of the low-temperature battery, because the temperature sensor sampling point is closer to the external environment than the battery, the sampling temperature thereof is lower than the actual battery temperature. Therefore, during the entire temperature variation process of the battery pack, the actual temperature variation of the battery will hysteresis behind the sampling temperature. Therefore, using the temperature collected by a temperature sensor to estimate the available total discharge capacity of the battery will lead to low estimation accuracy. Prior art documents CN111308357A, CN107748342 disclose battery capacity estimation methods.

### SUMMARY

The main object of the embodiments of the present application is to propose a battery capacity estimation method, an electronic device and a storage medium to improve the estimation accuracy of the available total discharge capacity of the battery.

In order to achieve the above object, in a first aspect, an embodiment of the present application provides a battery capacity estimation method. The method includes:
calculating a hysteresis coefficient corresponding to a current estimation period and calculating a first temperature rise variation coefficient corresponding to the current estimation period according to the hysteresis coefficient, where the hysteresis coefficient represents a hysteresis relationship between an actual battery thermal power and an average battery thermal power per unit time;
acquiring a first estimated temperature;
updating the first estimated temperature according to the first temperature rise variation coefficient, the first estimated temperature and a sensing temperature;
obtaining an estimated frozen capacity corresponding to the current estimation period according to the updated first estimated temperature and preset reference parameters; and
determining an estimated capacity of a battery according to the estimated frozen capacity.

In order to achieve the above object, in a second aspect, an embodiment of the present application provides an electronic device. The electronic device includes a memory and a processor, where the memory stores a computer program which, when executed by the processor, causes the processor to execute the method described in the first aspect.

In order to achieve the above object, in a third aspect, an embodiment of the present application provides a storage medium. The storage medium is a computer-readable storage medium. The storage medium stores a computer program which, when executed by the processor, causes the processor to execute the method described in the first aspect.

According to the battery capacity estimation method, electronic device and storage medium provided by the present application, a first temperature rise variation coefficient corresponding to a current estimation period is calculated according to a hysteresis coefficient, and a first estimated temperature is updated according to the first temperature rise variation coefficient, the first estimated temperature and a sensing temperature collected in the current estimation period. The updated first estimated temperature is used as a hysteresis temperature relative to the actual temperature detected by a sensor, and an estimated frozen capacity corresponding to the current estimation period is obtained according to the hysteresis temperature and preset reference parameters to obtain an estimated capacity. Therefore, compared with the existing technology in which an actual temperature adopted by a sensor is directly used to calculate an estimated capacity, the present application in which a hysteresis temperature is used to calculate an estimated capacity has the advantage that the calculated estimated capacity is more accurate. Therefore, embodiments of the present application can improve the estimation accuracy of the available total discharge capacity of the battery.

### BRIEF DESCRIPTION OF DRAWINGS

FIG 1(a) is a composition description of a rated capacity of a battery;
FIG 1(b) is a composition description of a rated capacity of a battery;
FIG 2 is a schematic flow chart of a battery capacity estimation method provided by an embodiment of the present application;
FIG 3 is a schematic diagram of calculation of an average current in a battery capacity estimation method provided by an embodiment of the present application;
FIG 4 is a schematic diagram of calculation of a first estimated temperature of a specific embodiment in a battery capacity estimation method provided by an embodiment of the present application;
FIG 5 is a flow chart of adjustment of an estimated frozen capacity of a specific embodiment in a battery capacity estimation method provided by an embodiment of the present application;
FIG 6 is a result verification diagram using a battery capacity estimation method provided by an embodiment of the present application; and
FIG. 7 is a schematic diagram of a hardware structure of an electronic device provided by an embodiment of the present application.

### DETAILED DESCRIPTION

In order to make the objects, technical solutions and advantages of the present application clearer, the present application will be further described in detail below with reference to the drawings and embodiments. It should be understood that the specific embodiments described here are only used to explain the present application and are not used to limit the present application.

It should be noted that although the functional modules are divided in the device schematic diagram and the logical sequence is shown in the flow chart, in some cases, the modules can be divided into different modules in the device or the order in the flow chart can be executed. The illustrated or described steps can be executed in module division different form that of the device or in the order in the flow chart. The terms "first", "second", and the like in the specification, claims, and above-mentioned drawings are used to distinguish similar objects, and are not necessarily used to describe a specific order or sequence.

Unless otherwise defined, all technical and scientific terms used herein have the same meaning as commonly understood by one of ordinary skill in the technical field to which the present application belongs. The terms used herein are only intended to describe the embodiments of the present application and are not intended to limit the present application.

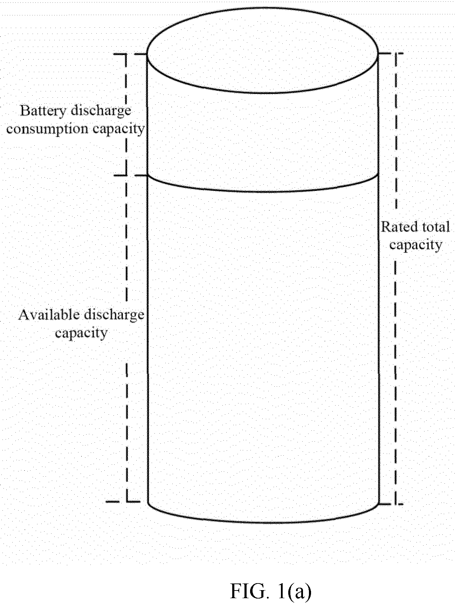

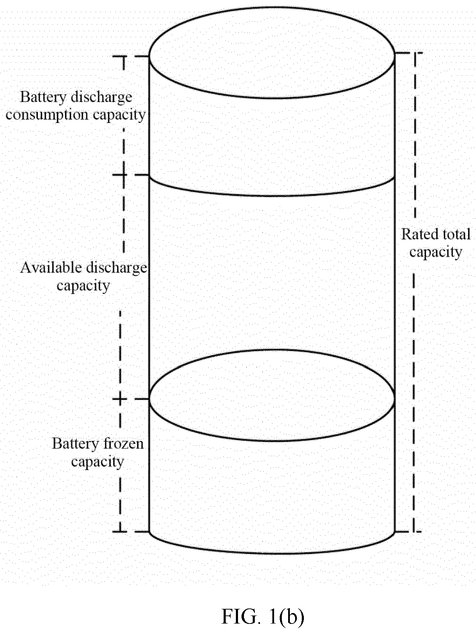

After batteries are assembled into a battery pack, temperature sensor sampling points will be arranged throughout the battery pack. During the discharge process, due to the concentrated heating of the battery, the temperature of local points rises rapidly, while the temperature rise at the opposite edges of the battery is slower than that at the local points. Meanwhile, due to the limited number of temperature sensor sampling points, when the temperature sensor sampling points fail to cover the opposite edges, that is, the actual lowest temperature of the battery cannot be collected, the temperature collected by the temperature collecting sensor is higher than the actual temperature. During the standing process of the low-temperature battery, because the temperature sensor sampling point is closer to the external environment than the battery, the sampling temperature thereof is lower than the actual battery temperature. Therefore, during the entire temperature variation process of the battery pack, the actual temperature variation of the battery will hysteresis behind the sampling temperature. For the estimation of the available discharge capacity of the battery, as shown in FIG 1(a), it is assumed that at a standard temperature, the rated total capacity of the battery is divided into a battery discharge consumption capacity Q_Expended and an available discharge capacity Q_Available. When the temperature variations (such as during the process of cooling down from the standard temperature, or rising from a lower temperature to the standard temperature), as shown in FIG 1(b), the rated total capacity of the same battery is divided into a battery discharge consumption capacity Q_Expended, a battery frozen capacity Q_Frozen and an available discharge capacity Q_Available at the current temperature, where the battery discharge consumption capacity Q*_*Expended and the available discharge capacity Q_Available are the available total discharge capacity of the battery. The temperature is strongly related to the battery frozen capacity Q_Frozen. Therefore, directly using the temperature collected by a temperature sensor to estimate the available total discharge capacity of the battery will lead to low estimation accuracy. On this basis, embodiments of the present application provide a battery capacity estimation method, an electronic device, and a storage medium to improve the estimation accuracy of the available total discharge capacity of the battery.

The battery capacity estimation method, electronic device and storage medium provided by the embodiments of the present application are specifically described through the following embodiments. First, the battery capacity estimation method in the embodiments of the present application is described.

The battery capacity estimation method provided by an embodiment of the present application relates to the technical field of batteries. The battery capacity estimation method provided by the embodiment of the present application can be applied to a terminal, or a server, or software running in the terminal or server. In some embodiments, the terminal can be a smartphone, a tablet, a laptop, a desktop computer, or the like; the server can be configured as an independent physical server, or as a server cluster or distributed system composed of multiple physical servers, or as a cloud server that provides basic cloud computing services such as cloud services, cloud databases, cloud computing, cloud functions, cloud storage, network services, cloud communications, middleware services, domain name services, security services, CDN, big data and artificial intelligence platforms, etc.; and the software can be an application of implementing the battery capacity estimation method, but is not limited to the above form.

The present application can be used in a variety of general or special purpose computer system environments or configurations, for example, personal computers, server computers, handheld or portable devices, tablet devices, multiprocessor systems, microprocessor-based systems, set-top boxes, programmable consumer electronics devices, network PCs, minicomputers, mainframe computers, distributed computing environments including any of the above systems or devices, or the like. The present application can be described in the general context of computer-executable instructions, such as program modules, executed by a computer. Generally, program modules include routines, programs, objects, components, data structures, etc. that perform particular tasks or implement particular abstract data types. The present application can also be practiced in distributed computing environments where tasks are performed by remote processing devices connected through a communications network. In a distributed computing environment, program modules can be located in both local and remote computer storage media including storage devices.

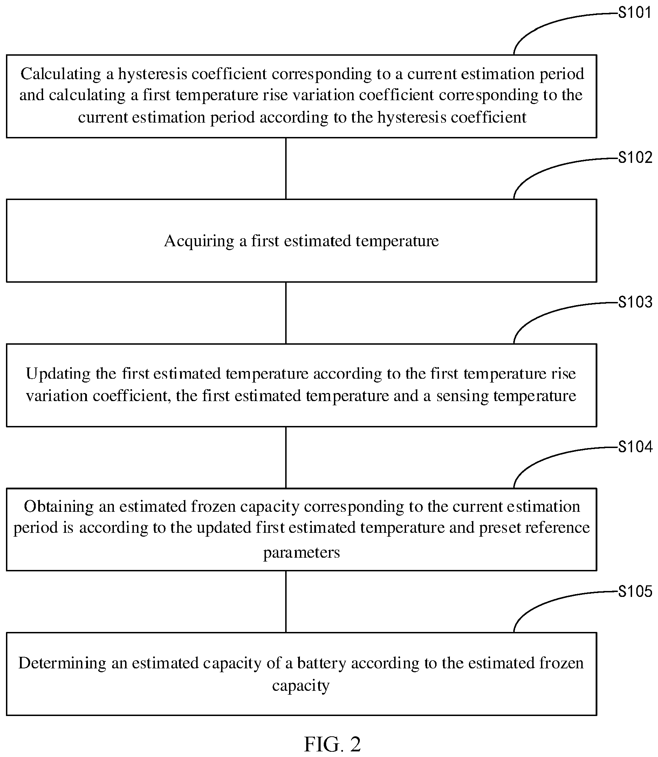

FIG. 2 is an optional flow chart of a battery capacity estimation method provided by an embodiment of the present application. The method in FIG. 2 can include, but is not limited to, steps S101 to S105.

Step S101: a hysteresis coefficient corresponding to a current estimation period is calculated and a first temperature rise variation coefficient corresponding to the current estimation period is calculated according to the hysteresis coefficient, where the hysteresis coefficient represents a hysteresis relationship between an actual battery thermal power and an average battery thermal power per unit time.

It should be noted that the hysteresis coefficient is calculated in real time; assuming that the battery thermal power is *I*² * *R*1**t,* the average battery thermal power is *I*_*avg*² * *R*2**t,* in some embodiments, the hysteresis coefficient is a = *I*² * *R*1**t* / *I_avg*² ** R2*t.* At the same temperature, the internal resistance of the battery is considered to be approximately the same per unit time, that is, *R1 = R*2. Therefore, in unit time, the hysteresis coefficient is *a =* 1/(*I_avg*/0.33C)² , that is, the hysteresis coefficient is a reciprocal of the square of the ratio of the average current to the charge-discharge multiple.

It should be noted that the first temperature rise variation coefficient represents a variation relationship between the collected temperature and time, and the variation relationship between the hysteresis temperature and time can be obtained by multiplying the first temperature rise variation coefficient and the hysteresis coefficient. Assuming that the initial first temperature rise variation coefficient is *k*₁, the hysteresis coefficient is *a*, and as time varies, the first temperature rise variation coefficient *k* = *k*₁ × *a.*

Step S102: a first estimated temperature is acquired.

It should be noted that the first estimated temperature is the temperature value estimated in the previous estimation period, which takes the starting temperature of the battery as an initial value and is updated in each estimation period. The starting temperature can be converted according to the current actual collected temperature, or calculated according to the estimated temperature before power-off. For example, when the current estimation period is a second estimation period, during the second estimation period, the value of the first estimated temperature is the value of the first estimated temperature at the end of the first estimation period.

Step S103: the first estimated temperature is updated according to the first temperature rise variation coefficient, the first estimated temperature and a sensing temperature.

It should be noted that the sensing temperature is the temperature collected from a collection point set on the battery; and if multiple collection points are set on the battery, the sensing temperature is the lowest temperature collected from the multiple collection points. It should be noted that according to the first temperature rise variation coefficient, the first estimated temperature and the sensing temperature, it is judged whether to update the first estimated temperature for the calculation of the estimated capacity of the battery, so that the calculation of the estimated capacity of the battery is updated only when the temperature variation reaches a certain threshold, improving the user experience. When the first estimated temperature is updated, the first temperature rise variation coefficient and the sensing temperature are comprehensively considered, which can further make the first estimated temperature to be closer to the actual battery temperature.

Step S104: an estimated frozen capacity corresponding to the current estimation period is obtained according to the updated first estimated temperature and preset reference parameters.

It should be noted that the reference parameters record reference values representing available discharge capacities at different temperatures measured according to experimental data. At this time, based on the reference value of the available discharge capacity, the estimated frozen capacity can be obtained.

Step S105: an estimated capacity of a battery is determined according to the estimated frozen capacity.

It should be noted that the estimated capacity represents the available total discharge capacity of the battery. Referring to FIG 1(a) and FIG 1(b), the available total discharge capacity is calculated from the rated capacity and the estimated frozen capacity.

Therefore, according to a hysteresis coefficient, a first temperature rise variation coefficient corresponding to a current estimation period is calculated, and a first estimated temperature is updated according to the first temperature rise variation coefficient, the first estimated temperature, and a sensing temperature collected during the current estimation period, the updated first estimated temperature is taken as a hysteresis temperature relative to an actual temperature detected by a sensor, and an estimated frozen capacity corresponding to the current estimation period is obtained according to the hysteresis temperature and the preset reference parameters to obtain an estimated capacity. Therefore, compared with the existing technology in which an actual temperature adopted by a sensor is directly used to calculate an estimated capacity, the present application in which a hysteresis temperature is used to calculate an estimated capacity has the advantage that the calculated estimated capacity is more accurate. Therefore, embodiments of the present application can improve the estimation accuracy of the available total discharge capacity of the battery.

It should be noted that in some embodiments, after a starting temperature is determined after power-on, the estimated capacity of the battery can be calculated in sequence with reference to steps S104 to S105. In other embodiments, after the starting temperature is determined after power-on, the estimated capacity can be calculated with reference to steps S101 to S105. It should be noted that steps S101 to S103 are judged and processed within one estimation period. Whether step S104 and step S105 are within the same estimation period is not restricted in the embodiment of the present application, and those skilled in the art can make adaptive changes according to actual conditions.

It can be understood that the calculating a first temperature rise variation coefficient corresponding to the current estimation period according to the hysteresis coefficient in step S101 includes:
acquiring a preset second temperature rise variation coefficient after power-on; and
multiplying the hysteresis coefficient and the preset second temperature rise variation coefficient to obtain the first temperature rise variation coefficient.

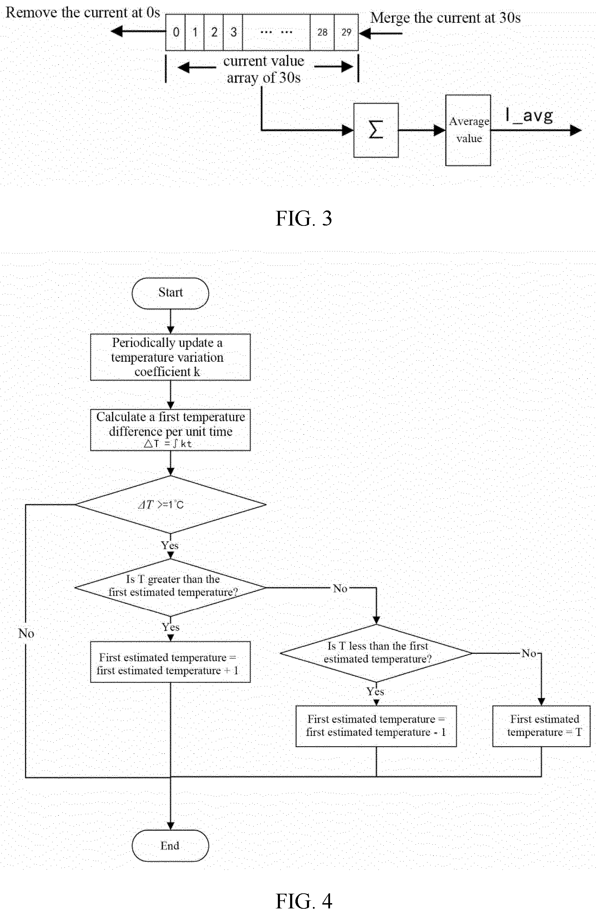

It should be noted that the average current represents the average value of currents within a continuous period of time. For example, as shown in FIG 3, the average current represents the average value of currents within 30s. At this time, a 30s current window can be set to collect the total current of the current window collected within 30s and calculate the average value to obtain the average current corresponding to the current moment. If the current moment is at the 30s, the current window moves to the 1s, and the total current from the 1s to the 30s is collected and average value is calculated to obtain the average current.

It can be understood that when the current estimation period is a first estimation period, the acquiring a first estimated temperature corresponding to the current estimation period in step S102 includes:
reading a historical estimated temperature from a preset position and acquiring a dormancy duration and a power-on temperature of the battery, when the battery is powered on;
calculating a second temperature difference according to the historical estimated temperature and the power-on temperature;
calculating a second estimated temperature according to the second temperature difference, the dormancy duration and a preset third temperature rise variation coefficient; and
taking the second estimated temperature as the first estimated temperature to be updated in the current estimation period.

It should be noted that the historical estimated temperature is the latest estimated temperature calculated before power-off. The dormancy duration represents a time interval from power-off to power-on, and the power-on temperature is the lowest temperature of temperatures collected by multiple sensors set on the battery. The third temperature rise variation coefficient represents a temperature variation trend when the battery is in a dormancy state.

In some embodiments, an estimated dormancy temperature difference can be calculated according to the third temperature rise variation coefficient and the dormancy duration, the dormancy temperature difference can be compared with the second temperature difference, and the first estimated temperature can be determined according to a comparison result. For example, assuming that the third temperature rise variation coefficient is *k*₀, the dormancy duration is *t*₀, then the dormancy temperature difference is *t*₀ ** k*₀; the second temperature difference *ΔT = T*_{c0}*-T*1, where *T*_{*c*0} is the power-on temperature; and *T*1 is the historical estimated temperature. If *ΔT* < 0 and |*ΔT*| > *t*₀ * *k*₀*,* then the second estimated temperature is *T*₀ *= T*1-*t*₀ ** k*₀; if *ΔT > 0* and |*ΔT*| > *t*₀ * *k*₀, then the second estimated temperature is *T*₀ *= T*1 + *t*₀ * *k*₀; and if the above conditions are not met, the second estimated temperature is *T*₀ *= T*_{*c*0}. The power-on temperature represents the sensing temperature collected during power-on.

It can be understood that the updating the first estimated temperature according to the first temperature rise variation coefficient, the first estimated temperature and a sensing temperature in step S103 includes:
calculating a first temperature difference corresponding to the first temperature rise variation coefficient per unit time;
comparing the sensing temperature with the first estimated temperature when the first temperature difference is greater than or equal to a preset temperature difference threshold; and
matching a comparison result with a preset update rule, and updating the first estimated temperature according to a matching result.

It should be noted that the temperature difference threshold is used to judge whether to perform temperature adjustment on the first estimated temperature to update the first estimated temperature. If there is no need for adjustment and the first estimated temperature remains unchanged, there is no need to recalculate the estimated capacity of the battery. In other embodiments, even if the first estimated temperature remains unchanged, a supplementary processing will be performed to reduce the probability of missed processing of the estimated capacity.

It should be noted that the update rule is to choose to increase the temperature difference threshold on the first estimated temperature, decrease the temperature difference threshold, or set the first estimated temperature as the minimum temperature *T* detected by a sensor at the current moment according to the values of the sensing temperature and the first estimated temperature.

It should be noted that the first temperature difference is *ΔT* = ∫*kt,* where *t* is the unit time in s. In this way, the first temperature difference used to determine the first estimated temperature can be close to the actual temperature difference, thereby making the measurement step of the first estimated temperature more accurate.

It can be understood that the matching a comparison result with the preset update rule, and updating the first estimated temperature according to a matching result includes:
when the sensing temperature is greater than the first estimated temperature, calculating a sum of the first estimated temperature and a preset temperature hysteresis stepping value and updating the first estimated temperature according to the sum;
when the sensing temperature is less than the first estimated temperature, calculating a difference between the first estimated temperature and the preset temperature hysteresis stepping value and updating the first estimated temperature according to the difference; and
when the sensing temperature is equal to the first estimated temperature, updating the first estimated temperature to the sensing temperature.

It should be noted that the preset temperature hysteresis stepping value represents a temperature difference value that increases or decreases the first estimated temperature in each estimation period. The preset temperature hysteresis stepping value can be set to the same value as the temperature difference threshold in some embodiments, and can also be set according to actual conditions in other embodiments.

For example, referring to FIG 4, the temperature difference threshold and the preset temperature hysteresis stepping value are both set to 1°C, the first temperature rise variation coefficient *k* is updated according to a preset estimation period and the corresponding first temperature difference *ΔT =* ∫*kt* within the estimation period is calculated; if the first temperature difference *ΔT* is greater than or equal to 1°C, it is judged whether the minimum temperature *T* detected at the current moment is greater than the first estimated temperature; if *T* is greater than the first estimated temperature, the first estimated temperature is updated to the first estimated temperature plus 1; if *T* is less than the first estimated temperature, the first estimated temperature is updated to the first estimated temperature minus 1; if *T* is equal to the first estimated temperature, the first estimated temperature is set to *T.* Specifically, assuming that the current estimation period is a first estimation period, as shown in FIG 4, if *T* is greater than the second estimated temperature, the first estimated temperature is updated to the second estimated temperature plus 1. Assuming that the current estimation period is a second estimation period, as shown in FIG 4, if *T* is greater than the value of the first estimated temperature updated in the first estimation period, the value of the current first estimated temperature is updated to the value of the first estimated temperature updated in the first estimation period plus 1.

It can be understood that the obtaining an estimated frozen capacity corresponding to the current estimation period according to the updated first estimated temperature and preset reference parameters in step S105 includes:
matching the updated first estimated temperature with a capacity data table within the current estimation period to determine a target available total capacity corresponding to the first estimated temperature, the capacity data table being one of the reference parameters; and
determining an estimated frozen capacity according to a rated reference capacity and the target available total capacity, the rated reference capacity being one of the reference parameters.

It should be noted that the capacity data table records the relationship between temperature and available total discharge capacity. The rated reference capacity is the total capacity of the battery at a standard temperature. For example, refer to the following Table 1:

**Table 1**

| Temperature /°C | -30°C | -20°C | -10°C | 0°C | 5°C | 10°C | 20°C | 25°C |
|---|---|---|---|---|---|---|---|---|
| Capacity/AH | Q7 | Q6 | Q5 | Q4 | Q3 | Q2 | Q1 | Q0 |

Taking Q7 as an example, it means that when the battery is at -30°C, the available total discharge capacity of the battery is Q7.

A theoretical reference frozen capacity can be obtained by subtracting the target available total capacity from the rated reference capacity. However, in actual conditions, there is a certain deviation between the theoretical reference frozen capacity and the actual frozen capacity, so the theoretical reference frozen capacity will be adjusted, to obtain the estimated frozen capacity. In some embodiments, for the rated reference capacity, the total capacity of the battery at a temperature of 25°C is selected as the rated reference capacity.

It can be understood that the determining an estimated frozen capacity according to a rated reference capacity and the target available total capacity includes:
subtracting the target available total capacity from the rated reference capacity to obtain a reference frozen capacity;
matching the updated first estimated temperature and a reference freezing parameter corresponding to the rated reference capacity with a preset capacity freezing coefficient table to obtain a capacity freezing coefficient; and
multiplying the capacity freezing coefficient and the reference frozen capacity to obtain the estimated frozen capacity.

It should be noted that referring to FIG 1(a), a reference freezing parameter represents a ratio of the available discharge capacity of the battery to the rated total capacity (corresponding to the rated reference capacity in the present application) at a standard temperature. The capacity freezing coefficient table records the capacity freezing coefficients corresponding to different reference freezing parameters at different temperatures. For example, the capacity freezing coefficient table is shown in Table 2 below:

**Table 2**

| Temp-SOC/Capacity | 0 | 5% | 10% | 20% | 30% | 40% | 50% | 60% | 70% | 80% | 90% | 100% |
|---|---|---|---|---|---|---|---|---|---|---|---|---|
| -30°C | 0 | 0.3 | 0.3 | 0.4 | 0.6 | 0.7 | 0.8 | 0.9 | 0.9 | 1.0 | 1.0 | 1.0 |
| -20°C | 0 | 0.3 | 0.3 | 0.5 | 0.6 | 0.7 | 0.8 | 0.9 | 0.9 | 1.0 | 1.0 | 1.0 |
| -10°C | 0 | 0.3 | 0.3 | 0.5 | 0.7 | 0.7 | 0.8 | 0.9 | 0.9 | 1.0 | 1.0 | 1.0 |
| 0°C | 0 | 0.4 | 0.4 | 0.5 | 1.0 | 1.0 | 1.0 | 1.0 | 1.0 | 1.0 | 1.0 | 1.0 |
| 5°C | 0 | 1.0 | 1.0 | 1.0 | 1.0 | 1.0 | 1.0 | 1.0 | 1.0 | 1.0 | 1.0 | 1.0 |
| 10°C | 0 | 1.0 | 1.0 | 1.0 | 1.0 | 1.0 | 1.0 | 1.0 | 1.0 | 1.0 | 1.0 | 1.0 |
| 20°C | 0 | 1.0 | 1.0 | 1.0 | 1.0 | 1.0 | 1.0 | 1.0 | 1.0 | 1.0 | 1.0 | 1.0 |
| 25°C | 0 | 1.0 | 1.0 | 1.0 | 1.0 | 1.0 | 1.0 | 1.0 | 1.0 | 1.0 | 1.0 | 1.0 |

For example, assuming that the reference frozen parameter is 70%, when the updated first estimated temperature is -10°C, the capacity frozen coefficient is 0.9. Then the estimated frozen capacity is the reference frozen capacity*0.9.

It can be understood that before the determining the estimated capacity of the battery according to the estimated frozen capacity in step S105, the method further includes:
determining whether a currently counted adjustment time interval reaches a preset duration;
when the adjustment time interval reaches the preset duration, comparing the estimated frozen capacity at the current moment with a previous adjusted estimated frozen capacity;
according to a comparison result, adjusting the estimated frozen capacity at the current moment according to a preset adjustment rules and re-counting the adjustment time interval.

Correspondingly, the determining the estimated capacity of the battery according to the estimated frozen capacity in step S105 includes:
subtracting the adjusted estimated frozen capacity from a rated reference capacity to obtain the estimated capacity of the battery, the rated reference capacity being one of the reference parameters.

It should be noted that the adjustment time interval represents a time interval between two adjustments to the estimated frozen capacity. The adjustment time interval is counted using a timer. For example, if the preset duration is set to 1s, a 200ms timer is used to count 5 times in a row, or a 1s timer is directly used. Preferably, in the present application, a timer is used to count multiple times, and the estimated frozen capacity is adjusted. The preset duration can be set according to actual conditions.

It should be noted that the adjustment rule is used to judge whether to perform preset capacity threshold adjustment on the estimated frozen capacity or to add/subtract the estimated frozen capacity to/from the preset adjustment threshold. If there is an adjustment to the estimated frozen capacity, the adjusted estimated frozen capacity will be used to calculate the estimated capacity.

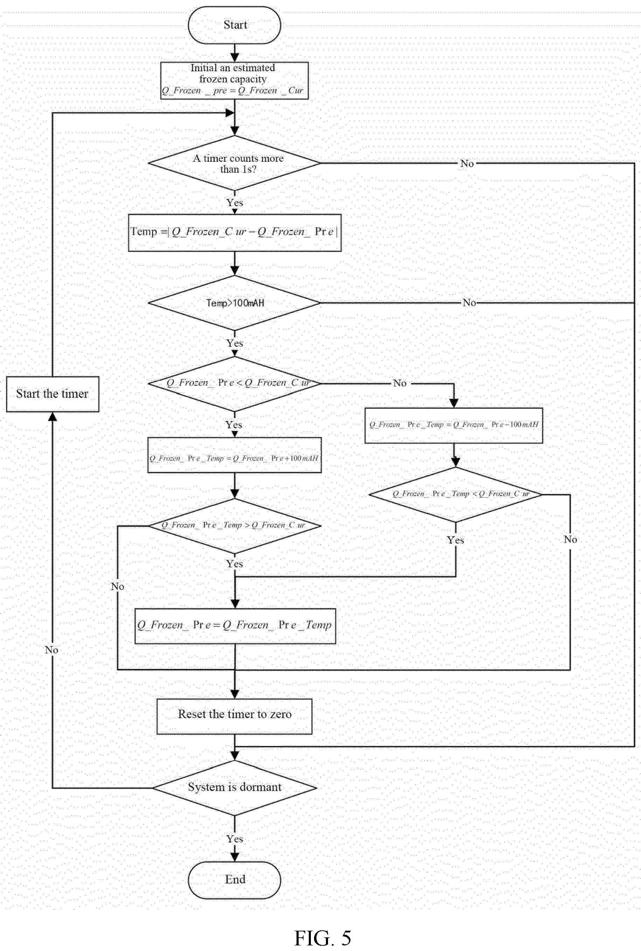

For example, referring to FIG. 5, the preset time length is set to 1s, and a 200ms timer is used to count the adjustment time interval. Assuming that the estimated frozen capacity corresponding to the previous adjustment time interval is *Q_Frozen_*Pr*e,* and the estimated frozen capacity at the current moment is *Q_Frozen_Cur*; at the initial stage of a program, when the estimated frozen capacity is calculated for the first time, the initial estimated frozen capacity *Q_Frozen_*Pr*e* is assigned as *Q_Frozen_Cur;* the timer is started to count the adjustment time; if the counted adjustment time interval is greater than 1s, when an absolute value of a difference (i.e. |*Q_Frozen_Cur-Q_Frozen*_Pr*e*|) between *Q_Frozen_Cur* and *Q_Frozen_*Pr*e* is less than or equal to a preset capacity threshold (assumed to be 100mAH), the timer is re-timed to re-count the adjustment time interval until |*Q_Frozen*_*Cur-Q*_Frozen _Pr*e*| is greater than the capacity threshold. At this time, when |*Q_Frozen_Cur-Q_Frozen*_Pr*e*| greater than the capacity threshold, when *Q_Frozen_*Pr*e* is less than *Q_Frozen_Cur* and the cumulative capacity threshold of *Q_Frozen_*Pr*e* is greater than *Q_Frozen_Cur,* the *Q_Frozen_Cur* at the current moment is updated to *Q_Frozen_*Pr*e* +100mAH; when *Q_Frozen_*Pr*e* is greater than or equal to *Q_Frozen_Cur* and *Q_Frozen_*Pr*e* -100mAH is less than *Q_Frozen_Cur,* the *Q_Frozen_Cur* at the current moment is updated to *Q_Frozen_*Pr*e*-100mAH. Otherwise, the timer will be reset to make the above judgment. Where, 100mAH is the adjustment threshold set in the adjustment rule. At this time, the updated *Q_Frozen_Cur* at the current moment is *Q_Frozen_*Pr*e* at the next moment. Therefore, in this way, a smooth transition is made between the two estimated frozen capacities used for estimated capacity calculation.

For example, taking a specific embodiment of the present application as an example, after the battery is powered on, the following operations are performed to estimate the available total discharge capacity:

### 1. Estimated temperature calculation

### (1) Calculate a second estimated temperature T₀ of the battery when powered on

The second estimated temperature *T*₀ of the battery when powered on is determined by the historical estimated temperature *T*1 stored when the battery is powered off, the dormancy duration *t*₀, and the lowest temperature *T*_{c0} of multiple temperatures sampled by the temperature sensor during power-on. The logic is as follows:
set a third temperature rise variation coefficient *k*₀ of the battery (specifically a static test value of the battery pack), the unit being °C/min; and calculate a dormancy temperature difference *t*₀ ** k*₀ between the temperatures before and after dormancy wake-up, the second temperature difference being *ΔT* = *T*_{*c*0}-*T*1.

If *ΔT* < 0 and |*ΔT*| > *t*₀ * *k*₀, the initial value of the estimated temperature is *T*₀ *= T*1-*t*₀ ** k*₀*.*

If *ΔT* > 0 and |*ΔT*| > *t*₀ * *k*₀, the initial value of the estimated temperature is *T*₀ *= T*1+*t*₀ **k*₀.

In other cases, the initial value of the estimated temperature is *T*₀ *= T*_{*c*0}. If the battery is powered on for the first time, the historical estimated temperature *T*1 is a preset value set according to experimental data.

### (2) Calculate a first temperature rise variation coefficient k during operation

a. Set a 30s current sliding average calculation window, as shown in FIG 3, obtain an average current *I_avg* corresponding to the 30s current window;
b. Take a temperature rise of 0.33C discharge test data of the battery as a reference, the initial second temperature rise variation coefficient being *k*₁, the unit being °C/min;
c. Calculate a hysteresis coefficient a of the temperature rise according to a ratio of the 30s average current I_avg to the 0.33C current, the calculation formula of the hysteresis coefficient being: *a =* 1/(*I_avg*/0.33C)², where the smaller the value of the hysteresis coefficient a of the temperature rise is, the closer the actual battery temperature to the temperature sensor sampling temperature is.
d. Calculate a first temperature rise variation coefficient *k* of the current battery, the formula being as follows: $k = {k}_{1} \times a ,$ the unit being °C/min;

### (3) Calculate a first estimated temperature T during operation

Referring to FIG. 4 , for example, as shown in FIG. 4 , the temperature difference threshold is set to 1°C, the first temperature rise variation coefficient *k* is updated periodically according to a preset estimation period, and a first temperature difference *ΔT* = ∫ *kt* corresponding to the unit time within the estimation period is calculated.; if the first temperature difference *ΔT* is greater than or equal to 1°C, it is judged whether the minimum temperature *T* detected at the current moment is greater than the first estimated temperature; at this time, if the minimum temperature *T* detected at the current moment is greater than the first estimated temperature, the first estimated temperature is updated to the first estimated temperature plus 1; if the minimum temperature *T* detected at the current moment is less than the first estimated temperature, the first estimated temperature is updated to the first estimated temperature minus 1; and if the minimum temperature *T* detected at the current moment is equal to the first estimated temperature, the first estimated temperature is updated to *T* .

### 2. Estimated capacity calculation

### (1) Capacity data table (see Table 1)

According to the capacity data of the battery at different temperatures, query the capacity data table with the updated first estimated temperature, and obtain a corresponding capacity value as the current target available total capacity;

### (2) Estimated capacity calculation

a. Obtain a reference frozen capacity by subtracting the target available total capacity *Q_Tpre* from the rated reference capacity *Q*max (i.e. the rated total capacity of the battery at 25°C), that is, *Q_Frozen = Q* max-*Q_Tpre*;
   Referring to Table 2, match the updated first estimated temperature and a reference frozen parameter corresponding to the rated reference capacity with a preset capacity freezing coefficient table (i.e. Table 2) to obtain a capacity freezing coefficient;
   Multiply the capacity freezing coefficient and the reference frozen capacity *Q*_*Frozen* to obtain the estimated frozen capacity *Q*_*Frozen*_*Cur.*
b. Add a smoothing filter module to smoothly transition the estimated frozen capacities in the two adjustment operation periods to adjust the current estimated frozen capacity *Q_Frozen*_*Cur;* specifically, as shown in FIG 5, adjust the current estimated frozen capacity.
c. When there is an estimated frozen capacity adjustment, the estimated capacity is *Q = Q* max-*Q*_*Frozen*_*cur.*

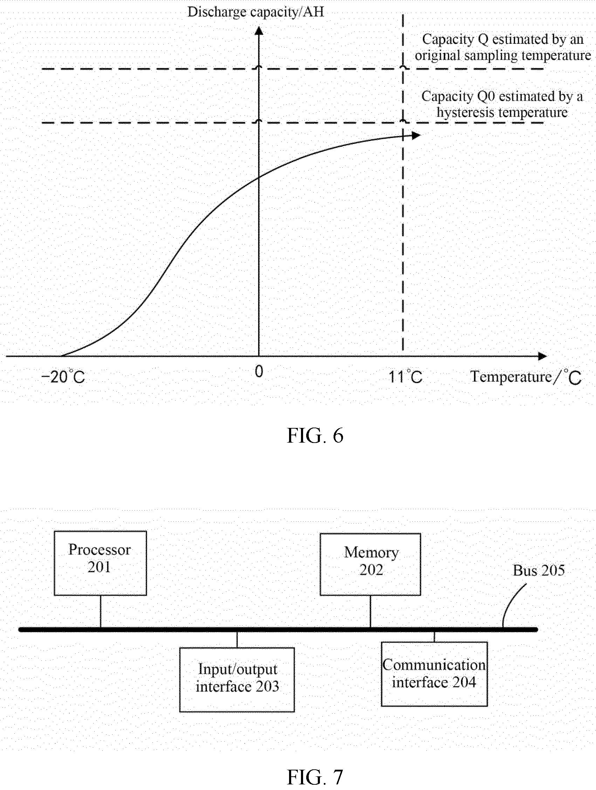

At this time, as shown in FIG 6, after an actual battery pack discharge test, according to discharge capacity results recorded by a test device, there is a large deviation between the actual discharge capacity and the available total capacity of the battery test data at this temperature, and the result thereof is closer to the capacity estimated using the hysteresis temperature in the battery capacity estimation method of the embodiment of the present application.

An embodiment of the present application also provides an electronic device. The electronic device includes a memory and a processor. The memory stores a computer program which, when executed by the processor, causes the processor to execute the above battery capacity estimation method. The electronic device can be any smart terminal including a tablet computer, a vehicle-mounted computer, or the like.

Referring to FIG 7, FIG 7 illustrates a hardware structure of an electronic device according to another embodiment. The electronic device includes: a processor 201, a memory 202, an input/output interface 203, a communication interface 204, and a bus 205.

The processor 201 can be implemented in the form of a general-purpose Central Processing Unit (, CPU), a microprocessor, an Application Specific Integrated Circuit (ASIC), or one or more integrated circuits, and is configured to execute relevant programs to implement the technical solutions provided by the embodiments of the present application.

The memory 202 can be implemented in the form of a Read Only Memory (ROM), a static storage device, a dynamic storage device, or a Random Access Memory (RAM). The memory 202 can store an operating system and other application programs. When the technical solutions provided by the embodiments of this specification are achieved through software or firmware, relevant program codes are stored in the memory 202 and are invoked by the processor 201 to perform the battery capacity estimation method in the embodiment of the present application.

The input/output interface 203 is configured to implement information input and output.

The communication interface 204 is configured to implement the communication interaction between this device and other devices. Communication can be implemented in wired means (such as USB, network cable, etc.) or wireless means (such as mobile network, WIFI, Bluetooth, etc.).

The bus 205 transmits information among various components of the device (such as the processor 201, the memory 202, the input/output interface 203, and the communication interface 204).

The processor 201, the memory 202, the input/output interface 203 and the communication interface 204 are communicatively connected one another in the device by the bus 205.

An embodiment of the present application also provides a storage medium. The storage medium is a computer-readable storage medium, and the storage medium stores a computer program which, when executed by a processor, causes the processor to execute the above battery capacity estimation method.

As a non-transitory computer-readable storage medium, the memory can be configured to store non-transitory software programs and non-transitory computer executable programs. In addition, the memory may include a high-speed random access memory and may also include a non-transitory memory, such as at least one magnetic disk storage device, a flash memory device, or other non-transitory solid-state storage device. In some implementations, the memory may optionally include memories located remotely with respect to the processor, and these remote memories may be connected to the processor via networks. Examples of the above-mentioned networks include, but are not limited to the Internet, intranet, local area network, mobile communication network and combinations thereof.

The embodiments described in the embodiments of the present application are intended to explain the technical solutions in the embodiments of the present application more clearly, and are not intended to constitute a limitation to the technical solutions provided by the embodiments of the present application. Those skilled in the art will know that with the evolution of technologies and the emergence of new application scenarios, the technical solutions provided by the embodiments of the present application are also applicable to similar technical problems.

Those skilled in the art can understand that the technical solutions shown in the drawings do not constitute a limitation to the embodiments of the present application, and can include more or less steps than those shown in the drawings, or combinations of certain steps, or different steps.

Those of ordinary skill in the art can understand that all or some steps, systems, and functional modules/units in the devices disclosed above can be implemented as software, firmware, hardware, and appropriate combinations thereof.

The terms "first", "second", "third", "fourth", etc. (if present) in the specification of the present application and the above-mentioned drawings are used to distinguish similar objects and are not necessarily used to describe a specific order or sequence. It should be understood that the data used in this way are interchangeable under appropriate circumstances so that the embodiments of the present application described herein can be practiced in sequences other than those illustrated or described herein. In addition, the terms "comprise" and "have" and any variations thereof are intended to cover non-exclusive inclusion, so that for example, a process, a method, a system, a product or a device which includes a series of steps or elements not only includes those steps or elements explicitly listed, but also includes other steps or elements not explicitly listed or inherent to the process, method, product or device.

It should be understood that in the present application, "at least one (item)" refers to one or more, and "a plurality of" refers to two or more. "And/or", which is used to describe the relationship between associated objects, indicates that there may be three relationships, for example, "A and/or B" may indicate A, A and B, and B, where A, B may be singular or plural. The character "/" generally indicates that there is a "or" relationship between the associated objects. "At least one of the following" and similar expressions thereof refer to any combination of these items, including any combination of single items or plural items. For example, at least one of a, b and c may represent: "a, b, c", "a and b", "a and c", "b and c", or "a and b and c", where a, b, c may be single or multiple.

The technical solutions of the present application essentially or the part that contributes to the relevant technology, or all or some of the technical solutions may be embodied in the form of a software product. The computer software product is stored in a storage medium, and includes multiple instructions for instructing a computer device (which may be a personal computer, a server, or a network device, etc.) to perform all or some of the steps of the methods of various embodiments of the present application. The aforementioned storage medium includes: USB flash disk, mobile hard disk, Read-Only Memory (ROM), Random Access Memory (RAM), magnetic disk or compact disc and other media that can store programs.

## Claims

1. A battery capacity estimation method, comprising:
calculating a hysteresis coefficient corresponding to a current estimation period and calculating a first temperature rise variation coefficient corresponding to the current estimation period according to the hysteresis coefficient (S101), wherein the hysteresis coefficient represents a hysteresis relationship between an actual battery thermal power and an average battery thermal power per unit time;
acquiring a first estimated temperature (S102);
updating the first estimated temperature according to the first temperature rise variation coefficient, the first estimated temperature and a sensing temperature (S103);
obtaining an estimated frozen capacity corresponding to the current estimation period according to the updated first estimated temperature and preset reference parameters (S104); and
determining an estimated capacity of a battery according to the estimated frozen capacity (S105).

2. The battery capacity estimation method according to claim 1, wherein the calculating the first temperature rise variation coefficient corresponding to the current estimation period according to the hysteresis coefficient comprises:
acquiring a preset second temperature rise variation coefficient after power-on; and
multiplying the hysteresis coefficient and the preset second temperature rise variation coefficient to obtain the first temperature rise variation coefficient.

3. The battery capacity estimation method according to claim 1, wherein when the current estimation period is a first estimation period, the acquiring the first estimated temperature comprises:
reading a historical estimated temperature from a preset position and acquiring a dormancy duration and a power-on temperature of the battery, when the battery is powered on;
calculating a second temperature difference according to the historical estimated temperature and the power-on temperature;
calculating a second estimated temperature according to the second temperature difference, the dormancy duration and a preset third temperature rise variation coefficient; and
taking the second estimated temperature as the first estimated temperature to be updated in the current estimation period.

4. The battery capacity estimation method according to claim 1, wherein the updating the first estimated temperature according to the first temperature rise variation coefficient, the first estimated temperature and the sensing temperature comprises:
calculating a first temperature difference corresponding to the first temperature rise variation coefficient per unit time;
comparing the sensing temperature with the first estimated temperature when the first temperature difference is greater than or equal to a preset temperature difference threshold; and
matching a comparison result with a preset update rule, and updating the first estimated temperature according to a matching result.

5. The battery capacity estimation method according to claim 4, wherein the matching the comparison result with the preset update rule, and updating the first estimated temperature according to the matching result comprises:
when the sensing temperature is greater than the first estimated temperature, calculating a sum of the first estimated temperature and a preset temperature hysteresis stepping value and updating the first estimated temperature according to the sum;
when the sensing temperature is less than the first estimated temperature, calculating a difference between the first estimated temperature and the preset temperature hysteresis stepping value and updating the first estimated temperature according to the difference; and
when the sensing temperature is equal to the first estimated temperature, updating the first estimated temperature to the sensing temperature.

6. The battery capacity estimation method according to claim 1, wherein the obtaining the estimated frozen capacity corresponding to the current estimation period according to the updated first estimated temperature and preset reference parameters comprises:
matching the updated first estimated temperature with a capacity data table within the current estimation period to determine a target available total capacity corresponding to the first estimated temperature, the capacity data table being one of the preset reference parameters; and
determining an estimated frozen capacity according to a rated reference capacity and the target available total capacity, the rated reference capacity being one of the preset reference parameters.

7. The battery capacity estimation method according to claim 6, wherein the determining the estimated frozen capacity according to the rated reference capacity and the target available total capacity comprises:
subtracting the target available total capacity from the rated reference capacity to obtain a reference frozen capacity;
matching the updated first estimated temperature and a reference freezing parameter corresponding to the rated reference capacity with a preset capacity freezing coefficient table to obtain a capacity freezing coefficient; and
multiplying the capacity freezing coefficient and the reference frozen capacity to obtain the estimated frozen capacity.

8. The battery capacity estimation method according to claim 1, wherein before the determining the estimated capacity of the battery, the method further comprises:
determining whether a currently counted adjustment time interval reaches a preset duration;
when the adjustment time interval reaches the preset duration, comparing the estimated frozen capacity at current moment with a previous adjusted estimated frozen capacity;
according to a comparison result, adjusting the estimated frozen capacity at the current moment according to preset adjustment rules and re-counting the adjustment time interval.

9. The battery capacity estimation method according to claim 8, wherein the determining the estimated capacity of a battery according to the estimated frozen capacity comprises:
subtracting the adjusted estimated frozen capacity from a rated reference capacity to obtain the estimated capacity of the battery, the rated reference capacity being one of the preset reference parameters.

10. The battery capacity estimation method according to claim 3, wherein the calculating the second estimated temperature according to the second temperature difference, the dormancy duration and the preset third temperature rise variation coefficient, comprises:
calculating an estimated dormancy temperature difference according to the preset third temperature rise variation coefficient and the dormancy duration;
comparing the estimated dormancy temperature difference with the second temperature difference; and
determining the first estimated temperature according to a comparison result.

11. The battery capacity estimation method according to claim 5, wherein preset temperature hysteresis stepping value is equal to the preset temperature difference threshold.

12. An electronic device, comprising a memory (202) and a processor (201), wherein the memory (202) stores a computer program which, when executed by the processor (201), causes the processor (201) to execute the battery capacity estimation method of any one of claims 1 to 11.

13. A computer-readable storage medium, storing a computer program which, when executed by a processor, causes the processor to execute the battery capacity estimation method of any one of claims 1 to 11.

## Patentansprüche

1. Verfahren zur Abschätzung der Batteriekapazität, umfassend:
Berechnen eines Hysterese-Koeffizienten, der einem aktuellen Schätzzeitraum entspricht, und Berechnen eines ersten Temperaturanstiegs-Variationskoeffizienten, der dem aktuellen Schätzzeitraum entspricht, gemäß dem Hysterese-Koeffizienten (S101), wobei der Hysterese-Koeffizient eine Hysterese-Beziehung zwischen einer tatsächlichen thermischen Leistung der Batterie und einer durchschnittlichen thermischen Leistung der Batterie pro Zeiteinheit darstellt;
Erfassen einer ersten geschätzten Temperatur (S102);
Aktualisieren der ersten geschätzten Temperatur entsprechend dem ersten Temperaturanstiegs-Variationskoeffizienten, der ersten geschätzten Temperatur und einer erfassten Temperatur (S103);
Ermitteln einer geschätzten gefrorenen Kapazität, die dem aktuellen Schätzzeitraum entspricht, gemäß der aktualisierten ersten geschätzten Temperatur und voreingestellten Referenzparametern (S104); und
Bestimmen einer geschätzten Kapazität einer Batterie entsprechend der geschätzten eingefrorenen Kapazität (S105).

2. Verfahren zur Abschätzung der Batteriekapazität nach Anspruch 1, wobei das Berechnen des ersten Temperaturanstiegs-Variationskoeffizienten, der dem aktuellen Schätzzeitraum entspricht, gemäß dem Hysterese-Koeffizienten umfasst:
Erfassen eines voreingestellten zweiten Temperaturanstiegs-Variationskoeffizienten nach dem Einschalten; und
Multiplizieren des Hysteresekoeffizienten mit dem voreingestellten zweiten Temperaturanstiegs-Variationskoeffizienten, um den ersten Temperaturanstiegs-Variationskoeffizienten zu erhalten.

3. Verfahren zur Abschätzung der Batteriekapazität nach Anspruch 1, wobei, wenn der aktuelle Abschätzungszeitraum ein erster Abschätzungszeitraum ist, das Ermitteln der ersten geschätzten Temperatur umfasst:
das Auslesen einer historischen geschätzten Temperatur von einer voreingestellten Position und das Erfassen einer Ruhezeitdauer sowie einer Einschalttemperatur der Batterie, wenn die Batterie eingeschaltet wird;
Berechnen einer zweiten Temperaturdifferenz anhand der historischen geschätzten Temperatur und der Einschalttemperatur;
Berechnen einer zweiten geschätzten Temperatur anhand der zweiten Temperaturdifferenz, der Ruhezeitdauer und eines voreingestellten dritten Temperaturanstiegs-Variationskoeffizienten; und
die zweite geschätzte Temperatur als die erste geschätzte Temperatur zu verwenden, die im aktuellen Schätzzeitraum aktualisiert werden soll.

4. Verfahren zur Schätzung der Batteriekapazität nach Anspruch 1, wobei die Aktualisierung der ersten geschätzten Temperatur gemäß dem ersten Temperaturanstiegs-Variationskoeffizienten erfolgt, wobei die erste geschätzte
Temperatur und die Erfassungstemperatur umfasst:
Berechnen einer ersten Temperaturdifferenz, die dem ersten Temperaturanstiegs-Variationskoeffizienten pro Zeiteinheit entspricht;
Vergleichen der gemessenen Temperatur mit der ersten geschätzten Temperatur, wenn die erste Temperaturdifferenz größer oder gleich einem voreingestellten Temperaturdifferenzschwellenwert ist; und
Abgleichen eines Vergleichsergebnisses mit einer voreingestellten Aktualisierungsregel und Aktualisieren der ersten geschätzten Temperatur entsprechend einem Abgleichergebnis.

5. Verfahren zur Schätzung der Batteriekapazität nach Anspruch 4, wobei das Abgleichen des Vergleichsergebnisses mit der voreingestellten Aktualisierungsregel und das Aktualisieren der ersten geschätzten Temperatur entsprechend dem Abgleichergebnis umfasst:
wenn die gemessene Temperatur größer ist als die erste geschätzte Temperatur, Berechnen einer Summe aus der ersten geschätzten Temperatur und einem voreingestellten Temperaturhysterese-Schrittwert und Aktualisieren der ersten geschätzten Temperatur entsprechend der Summe;
wenn die gemessene Temperatur kleiner als die erste geschätzte Temperatur ist, Berechnen einer Differenz zwischen der ersten geschätzten Temperatur und dem voreingestellten Temperaturhysterese-Schrittwert und Aktualisieren der ersten geschätzten Temperatur entsprechend der Differenz; und
wenn die gemessene Temperatur gleich der ersten geschätzten Temperatur ist, das Aktualisieren der ersten geschätzten Temperatur auf die gemessene Temperatur.

6. Verfahren zur Schätzung der Batteriekapazität nach Anspruch 1, wobei das Ermitteln der geschätzten gefrorenen Kapazität, die dem aktuellen Schätzzeitraum entspricht, gemäß der aktualisierten ersten geschätzten Temperatur und voreingestellten Referenzparametern umfasst:
Abgleichen der aktualisierten ersten geschätzten Temperatur mit einer Kapazitätsdatentabelle innerhalb des aktuellen Schätzzeitraums, um eine der ersten geschätzten Temperatur entsprechende angestrebte verfügbare Gesamtkapazität zu ermitteln, wobei die Kapazitätsdatentabelle einer der voreingestellten Referenzparameter ist; und
Ermitteln einer geschätzten eingefrorenen Kapazität gemäß einer NennReferenzkapazität und der angestrebten verfügbaren Gesamtkapazität, wobei die NennReferenzkapazität einer der voreingestellten Referenzparameter ist.

7. Verfahren zur Schätzung der Batteriekapazität nach Anspruch 6, wobei das Bestimmen der geschätzten eingefrorenen Kapazität gemäß der Nennreferenzkapazität und der angestrebten verfügbaren Gesamtkapazität umfasst:
Subtrahieren der angestrebten verfügbaren Gesamtkapazität von der NennReferenzkapazität, um eine Referenz-Gefrierkapazität zu erhalten;
Abgleichen der aktualisierten ersten geschätzten Temperatur und eines Referenz-Einfrierparameters, der der Nenn-Referenzleistung entspricht, mit einer voreingestellten Tabelle von Leistungseinfrierkoeffizienten, um einen Leistungseinfrierkoeffizienten zu erhalten; und
Multiplizieren des Kapazitäts-Einfrierkoeffizienten mit der Referenz-Einfrierkapazität, um die geschätzte Einfrierkapazität zu erhalten.

8. Verfahren zur Abschätzung der Batteriekapazität nach Anspruch 1, wobei das Verfahren vor der Bestimmung der geschätzten Kapazität der Batterie ferner umfasst:
Feststellen, ob ein aktuell gezähltes Anpassungszeitintervall eine voreingestellte Dauer erreicht;
wenn das Anpassungszeitintervall die voreingestellte Dauer erreicht, den Vergleich der geschätzten eingefrorenen Kapazität zum aktuellen Zeitpunkt mit einer zuvor angepassten geschätzten eingefrorenen Kapazität;
je nach Vergleichsergebnis die geschätzte eingefrorene Kapazität zum aktuellen Zeitpunkt gemäß voreingestellten Anpassungsregeln anzupassen und das Anpassungszeitintervall neu zu zählen.

9. Verfahren zur Schätzung der Batteriekapazität nach Anspruch 8, wobei das Bestimmen der geschätzten Kapazität einer Batterie anhand der geschätzten eingefrorenen Kapazität umfasst:
Subtrahieren der angepassten geschätzten eingefrorenen Kapazität von einer NennReferenzkapazität, um die geschätzte Kapazität der Batterie zu erhalten, wobei die NennReferenzkapazität einer der voreingestellten Referenzparameter ist.

10. Verfahren zur Schätzung der Batteriekapazität nach Anspruch 3, wobei das Berechnen der zweiten geschätzten Temperatur gemäß der zweiten Temperaturdifferenz, der Ruhezeitdauer und dem voreingestellten dritten Temperaturanstiegs-Variationskoeffizienten umfasst:
Berechnen einer geschätzten Ruhe-Temperaturdifferenz gemäß dem voreingestellten dritten Temperaturanstiegs-Variationskoeffizienten und der Ruhe-Dauer;
Vergleichen der geschätzten Ruhe-Temperaturdifferenz mit der zweiten Temperaturdifferenz; und
Ermitteln der ersten geschätzten Temperatur entsprechend einem Vergleichsergebnis.

11. Verfahren zur Schätzung der Batteriekapazität nach Anspruch 5, wobei der voreingestellte Temperaturhysterese-Schrittwert gleich dem voreingestellten Temperaturdifferenzschwellenwert ist.

12. Elektronisches Gerät, umfassend einen Speicher (202) und einen Prozessor (201), wobei der Speicher (202) ein Computerprogramm speichert, das, wenn es vom Prozessor (201) ausgeführt wird, den Prozessor (201) veranlasst, das Verfahren zur Abschätzung der Batteriekapazität gemäß einem der Ansprüche 1 bis 11 auszuführen.

13. Ein computerlesbares Speichermedium, auf dem ein Computerprogramm gespeichert ist, das, wenn es vom
einen Prozessor, der den Prozessor veranlasst, das Verfahren zur Schätzung der Batteriekapazität gemäß einem der Ansprüche 1 bis 11 auszuführen.

## Revendications

1. Procédé d'estimation de la capacité d'une batterie, comprenant :
le calcul d'un coefficient d'hystérésis correspondant à une période d'estimation en cours et le calcul d'un premier coefficient de variation de l'élévation de température correspondant à la période d'estimation en cours en fonction du coefficient d'hystérésis (S101), le coefficient d'hystérésis représentant une relation d'hystérésis entre la puissance thermique réelle de la batterie et la puissance thermique moyenne de la batterie par unité de temps ;
l'acquisition d'une première température estimée (S102) ;
la mise à jour de la première température estimée en fonction du premier coefficient de variation de l'élévation de température, de la première température estimée et d'une température mesurée (S103) ;
obtenir une capacité estimée à l'état gelé correspondant à la période d'estimation en cours en fonction de la première température estimée mise à jour et de paramètres de référence prédéfinis (S104) ; et
déterminer une capacité estimée d'une batterie en fonction de la capacité gelée estimée (S105).

2. Procédé d'estimation de la capacité d'une batterie selon la revendication 1, dans lequel le calcul du premier coefficient de variation de l'élévation de température correspondant à la période d'estimation en cours en fonction du coefficient d'hystérésis comprend :
l'acquisition d'un deuxième coefficient de variation de l'élévation de température prédéfini après la mise sous tension ; et
la multiplication du coefficient d'hystérésis par le deuxième coefficient de variation de l'élévation de température prédéfini afin d'obtenir le premier coefficient de variation de l'élévation de température.

3. Procédé d'estimation de la capacité d'une batterie selon la revendication 1, dans lequel, lorsque la période d'estimation en cours est une première période d'estimation, l'acquisition de la première température estimée comprend :
la lecture d'une température estimée historique à partir d'une position prédéfinie et l'acquisition d'une durée de veille et d'une température de mise sous tension de la batterie, lorsque la batterie est mise sous tension ;
le calcul d'une deuxième différence de température en fonction de la température estimée historique et de la température à la mise sous tension ;
le calcul d'une deuxième température estimée en fonction de la deuxième différence de température, de la durée de veille et d'un troisième coefficient de variation de l'élévation de température prédéfini ; et
considérer la deuxième température estimée comme la première température estimée à mettre à jour au cours de la période d'estimation actuelle.

4. Procédé d'estimation de la capacité d'une batterie selon la revendication 1, dans lequel la mise à jour de la première température estimée en fonction du premier coefficient de variation de l'élévation de température, la première température estimée
température et la température mesurée, comprenant :
le calcul d'une première différence de température correspondant au premier coefficient de variation de l'élévation de température par unité de temps ;
la comparaison de la température mesurée avec la première température estimée lorsque la première différence de température est supérieure ou égale à un seuil de différence de température prédéfini ; et
la mise en correspondance d'un résultat de comparaison avec une règle de mise à jour prédéfinie, et la mise à jour de la première température estimée en fonction d'un résultat de mise en correspondance.

5. Procédé d'estimation de la capacité d'une batterie selon la revendication 4, dans lequel la mise en correspondance du résultat de la comparaison avec la règle de mise à jour prédéfinie, et la mise à jour de la première température estimée en fonction du résultat de la mise en correspondance, comprennent :
lorsque la température mesurée est supérieure à la première température estimée, le calcul d'une somme de la première température estimée et d'une valeur de pas d'hystérésis de température prédéfinie, et la mise à jour de la première température estimée en fonction de cette somme ;
lorsque la température détectée est inférieure à la première température estimée, le calcul d'une différence entre la première température estimée et la valeur de pas d'hystérésis de température prédéfinie, et la mise à jour de la première température estimée en fonction de cette différence ; et
lorsque la température mesurée est égale à la première température estimée, la mise à jour de la première température estimée à la température mesurée.

6. Procédé d'estimation de la capacité d'une batterie selon la revendication 1, dans lequel l'obtention de la capacité estimée gelée correspondant à la période d'estimation en cours, en fonction de la première température estimée mise à jour et de paramètres de référence prédéfinis, comprend :
la mise en correspondance de la première température estimée mise à jour avec un tableau de données de capacité au sein de la période d'estimation en cours afin de déterminer une capacité totale disponible cible correspondant à la première température estimée, le tableau de données de capacité étant l'un des paramètres de référence prédéfinis ; et
la détermination d'une capacité gelée estimée en fonction d'une capacité de référence nominale et de la capacité totale disponible cible, la capacité de référence nominale faisant partie des paramètres de référence prédéfinis.

7. Procédé d'estimation de la capacité d'une batterie selon la revendication 6, dans lequel la détermination de la capacité gelée estimée en fonction de la capacité de référence nominale et de la capacité totale disponible cible comprend :
soustraire la capacité totale disponible cible de la capacité de référence nominale pour obtenir une capacité de référence gelée ;
faire correspondre la première température estimée mise à jour et un paramètre de gel de référence correspondant à la capacité de référence nominale à un tableau prédéfini de coefficients de gel de capacité afin d'obtenir un coefficient de gel de capacité ; et
multiplier le coefficient de gel de capacité par la capacité de référence gelée afin d'obtenir la capacité estimée gelée.

8. Procédé d'estimation de la capacité d'une batterie selon la revendication 1, dans lequel, avant de déterminer la capacité estimée de la batterie, le procédé comprend en outre :
déterminer si un intervalle de temps d'ajustement actuellement compté atteint une durée prédéfinie ;
lorsque l'intervalle de temps d'ajustement atteint la durée prédéfinie, comparer la capacité gelée estimée à l'instant présent avec une capacité gelée estimée précédemment ajustée ;
en fonction du résultat de la comparaison, ajuster la capacité gelée estimée à l'instant présent selon des règles d'ajustement prédéfinies et recommencer à compter l'intervalle de temps d'ajustement.

9. Procédé d'estimation de la capacité d'une batterie selon la revendication 8, dans lequel la détermination de la capacité estimée d'une batterie en fonction de la capacité gelée estimée comprend :
soustraire la capacité gelée estimée ajustée d'une capacité de référence nominale pour obtenir la capacité estimée de la batterie, la capacité de référence nominale étant l'un des paramètres de référence prédéfinis.

10. Procédé d'estimation de la capacité d'une batterie selon la revendication 3, dans lequel le calcul de la deuxième température estimée en fonction de la deuxième différence de température, de la durée de dormance et du troisième coefficient de variation de l'élévation de température prédéfini comprend :
le calcul d'une différence de température de dormance estimée en fonction du troisième coefficient de variation de l'élévation de température prédéfini et de la durée de dormance ;
la comparaison de la différence de température de dormance estimée avec la deuxième différence de température ; et
déterminer la première température estimée en fonction d'un résultat de comparaison.

11. Procédé d'estimation de la capacité d'une batterie selon la revendication 5, dans lequel la valeur de pas d'hystérésis de température prédéfinie est égale au seuil de différence de température prédéfini.

12. Dispositif électronique, comprenant une mémoire (202) et un processeur (201), dans lequel la mémoire (202) stocke un programme informatique qui, lorsqu'il est exécuté par le processeur (201), amène le processeur (201) à exécuter le procédé d'estimation de la capacité de la batterie selon l'une quelconque des revendications 1 à 11.

13. Support de stockage lisible par ordinateur, stockant un programme informatique qui, lorsqu'il est exécuté par
un processeur, amène le processeur à exécuter le procédé d'estimation de la capacité de la batterie selon l'une quelconque des revendications 1 à 11.
